# EUROPEAN PATENT APPLICATION

(11) **EP 1 879 267 A2**
(43) Date of publication of application: **16.01.2008**
(21) Application number: 07117664.8
(22) Date of filing: 21.05.2004
(51) Int. Cl.: H01R 43/20, H01R 12/20

(54) **Press fitting apparatus and related method**

(30) Priority: 23.05.2003 JP 2003146596
(62) Divisional of application: 04253016.2
(71) Applicant: Tyco Electronics AMP K.K., Kawasaki, Kanagawa 213-8535 (JP)
(72) Inventor: Ikeda, Yuji, Kawasaki-shi Kanagawa 213-8535 (JP); Maruyama, Kiyomi, Kawasaki-shi Kanagawa 213-8535 (JP)
(74) Representative: Bankes, Stephen Charles Digby

(57) **Abstract**

The invention concerns an apparatus equipped with a substrate mounting section (130), a connector mounting section (120), and a press fitting head (10) which positions and press-fits roughly L-shaped legs of a connector (20) into a substrate (30). The connector (20) has multiple rows of contacts (21,22) equipped with the legs and press fit sections (21 a,22a) provided near the lower ends of the legs. The apparatus further comprises a locating plate (140) which positions the lower ends of the legs, wherein the locating plate (140) is retractable downwardly from a positioning site where the lower ends of the legs are positioned.

## Description

The present invention relates to a press fitting head which positions roughly L-shaped legs of a connector holding multiple rows of contacts equipped with the legs and press fit sections provided near the lower end of the legs and press-fits the legs into a substrate, an apparatus equipped with the press fitting head, and a method for press fitting.

Conventionally, in a connector with multiple rows of contacts which are equipped with roughly L-shaped legs and which overlap in the vertical direction with corresponding contacts in different rows, the contacts are press-fitted into a substrate.

When press-fitting the contacts of the connector into the substrate, although the contacts in the top row can be pressed from above, the contacts in the lower rows cannot be pressed from above because the upper contacts get in the way if no measure is taken.

A solution to this problem is proposed in Japanese laid-open patent No. 2003-68419.

The technique proposed in JP 2003-68419 involves preparing a press fitting jig with a comb-shaped part vertically grooved with the same pitch as the spacing pitch of the contacts so that a pair of contacts arranged vertically enter a groove, fitting each pair of contacts into each vertical groove in the press fitting jig, and slightly moving the press fitting jig or connector relative to each other in the spacing direction of the contacts with the contacts fitted.

The press fitting jig has horizontal grooves to accept upper and lower contacts which have moved slightly in the direction described above (the spacing direction of the contacts) when the pair of the upper and lower contacts have entered the vertical groove. Consequently, walls of the press fitting jig are applied not only to the upper contacts, but also to the lower contacts, allowing the press fitting jig to press down all the contacts in the connector, and thus press-fit them into the substrate.

Furthermore, Japanese laid-open patent 8-69828 discloses a technique which involves pressing a somewhat wide shoulder section formed on each contact. Although the upper and lower contacts overlap on the whole, their shoulder sections are formed in such a way that they do not overlap: the shoulder sections of the lower contacts stick out from the shoulder sections of the upper contacts when viewed from above. This makes it possible to press down the shoulder sections of all the contacts overlapping vertically and press-fit all the contacts of the connector into a substrate.

The technique disclosed in JP 2003-68419 press-fits the contacts into a substrate with the contacts engaged with the vertical grooves and horizontal grooves. Since the vertical grooves and horizontal grooves are connected to each other, if even one of the lower contacts disengages from the horizontal groove due to, for example, misalignment or bend, the corresponding upper contact is not pressed, which may result in an improper press fit.

Also, even if there is no disengagement from the horizontal groove, since the part pressed and the part actually fitted are fairly distant from each other especially in the case of the upper contacts, any upper contact that is bent even slightly may buckle in the middle when pressed to be fitted.

Furthermore, a large number of contacts must be positioned reliably and press-fitted into press fit holes in a substrate. Although not disclosed in JP 2003-68419, a technique called tine alignment is used for the purpose of positioning. It involves press-fitting a terminal alignment plate attached to the bottom of a connector directly into a substrate. In this case, the terminal alignment plate which is no longer necessary is left fitted in the substrate together with the press-fitted connector, increasing the cost accordingly.

On the other hand, the technique which involves providing shoulder sections, disclosed in JP 8-69828, has the advantage of being able to install the shoulder sections in such a way as to be visible from above, and thus press-fit the contacts simply by moving the press fitting jig vertically as well as the advantage of being able to prevent buckling by installing the shoulder sections at a location close to the part actually press-fitted. However, this technique presents the problem, for example, of how to avoid a situation in which a slight displacement or bend of a contact will cause the shoulder section of the contact to deviate from the position where it should normally be pressed, making it impossible for the press fitting jig to press the contact and resulting in an improper press fit. Besides, JP 8-69828 does not mention positioning between contacts and press fit holes in the substrate. Thus, it is necessary to use a terminal alignment plate such as the one described above and leave it fitted in the substrate each time a connector is press-fitted.

In view of the above circumstances, the present invention has an object to provide a press fitting head which can reliably press-fit a connector holding multiple rows of contacts into a substrate, an apparatus equipped with the press fitting head, and a method for press fitting which can press-fit the connector reliably into the substrate and reduce manufacturing costs.

To achieve the above object, the present invention provides an apparatus equipped with a substrate mounting section, a connector mounting section, and a press fitting head which positions and press-fits roughly L-shaped legs of a connector into a substrate, wherein the connector has or holds multiple rows of contacts equipped with the legs and press fit sections provided near the lower end of the legs, the press fitting apparatus further having: a locating plate which positions the lower end of the legs, wherein the locating plate is retractable downwardly from a positioning site where the lower end of the legs are positioned.

The apparatus according to the present invention is equipped with the locating plate which positions the lower end of the legs, allowing the contacts to be positioned at predetermined places in the substrate.

Besides, since the locating plate is retractable from the positioning site, it can be retracted prior to actual press fitting into the substrate, eliminating the need for a conventional unrecoverable terminal alignment plate and reducing cost.

In the press fitting apparatus according to the present invention, preferably the press fitting head has: abutment sections which abut shoulders installed on top of the press fit sections of the connector; right/left positioning walls which position the shoulders in the right-and-left direction; and forward/backward positioning walls which position the shoulders in the forward-and-backward direction.

In this configuration, the contacts positioned by the locating plate before press fitting are held securely by the press fitting head and the shoulders are reliably prevented from running or slipping off the abutment sections. Consequently, the contacts are press-fitted into the substrate more reliably.

Also, to achieve the above object, the present invention provides a press fitting method, including the steps of: mounting a substrate on a substrate mounting section; inserting roughly L-shaped legs of a connector into holes in a locating plate placed at a predetermined positioning site to align the legs and mounting the connector on a connector mounting section, where the connector has or holds multiple rows of contacts equipped with the legs and press fit sections provided near the lower ends of the legs; placing a press fitting head on the legs; retracting the locating plate from the positioning site; and lowering the press fitting head and press-fitting the legs into press fit holes in the substrate.

The press fitting method according to the present invention enables reliable press fitting, allows the locating plate to be reused repeatedly, eliminates the need for a conventional unrecoverable terminal alignment plate, and reduces costs.

As described above, the present invention allows reliable press fitting into substrates.

The invention will now be described by way of example only with reference to the accompanying darwings in which:
Fig. 1 is a diagram showing a press fitting head and a connector press-fitted into a substrate by the press fitting head according to an embodiment of the present invention, where part (a) is a front view and part (b) is a side view;
Fig. 2 is a partially enlarged view of the press fitting head and connector shown in Fig. 1, with the connector press-fitted into press fit holes in the substrate, where part (a) is a front view and part (b) is a side view;
Fig. 3 is a side view of a press fitting apparatus according to the embodiment of the present invention;
Fig. 4 is a side view of the press fitting apparatus according to the embodiment of the present invention;
Fig. 5 is a side view of the press fitting apparatus according to the embodiment of the present invention;
Fig. 6 is a side view of the press fitting apparatus according to the embodiment of the present invention;
Fig. 7 is a side view of the press fitting apparatus according to the embodiment of the present invention;
Fig. 8 is a side view of the press fitting apparatus according to the embodiment of the present invention;
Fig. 9 is a perspective view of the press fitting apparatus whose side views are shown in Figs. 3 to 8;
Fig. 10 is a perspective view, partly in section, showing the press fitting apparatus before press fitting;
Fig. 11 is s a perspective view, partly in section, showing the press fitting apparatus after press fitting; and
Fig. 12 is a flowchart of a press fitting method according to the embodiment of the present invention.

An embodiment of the present invention will be described below.

The press fitting head 10 is secured to a support arm 110 with a bolt 11. The connector 20 is mounted on a connector mounting section 120.

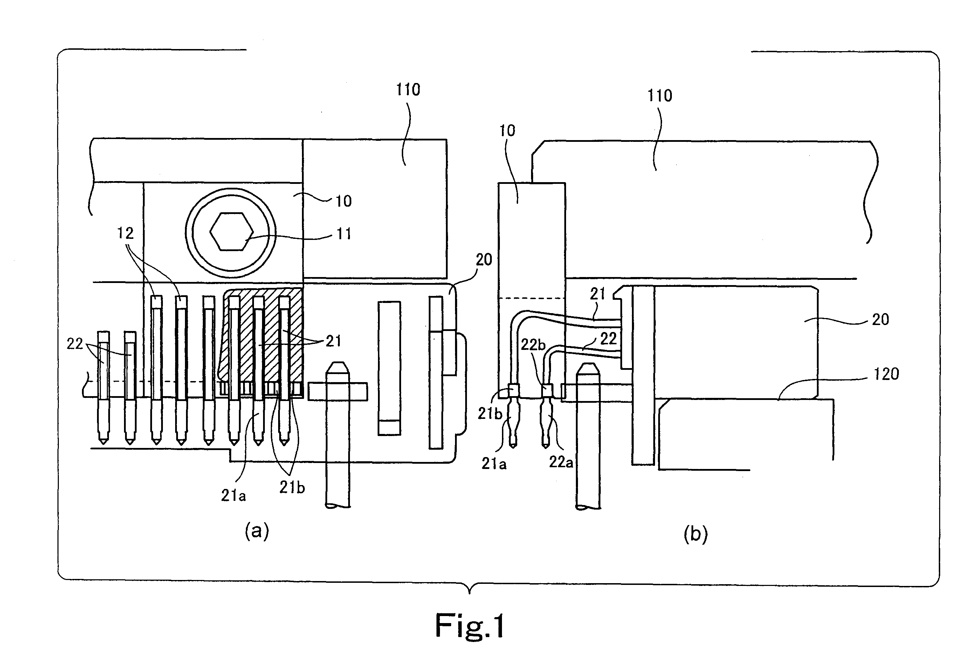

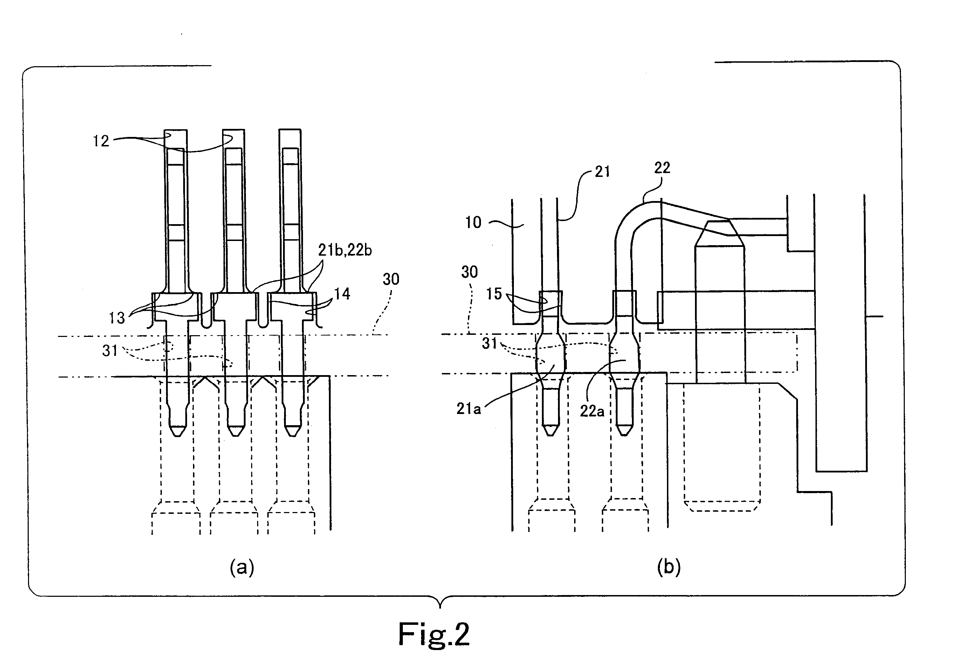

As shown in Part (b) of Fig. 1, the connector 20 has two rows-upper and lower rows-of roughly L-shaped contacts 21 and 22. The contacts overlap vertically. A large number of contacts are arranged with a predetermined pitch in the direction perpendicular to the paper in part (b) of Fig. 1. At the bottom of the contacts 21 and 22 are press fit sections 21 a and 22a to be press-fitted into the substrate. Slightly above the press fit sections 21 a and 22a are shoulders 21 b and 22b sticking out in the width direction of the contacts 21 and 22, as shown in part (a) of Fig. 2.

As shown in part (a) of Fig. 2, the press fitting head 10 has vertical grooves 12 formed with the same pitch as the arrangement pitch of the contacts 21 and 22. In the vertical grooves 12, there are abutment sections 13 facing the shoulders 21 b and 22b of the contacts 21 and 22. Just below the abutment sections 13, there are right/left positioning walls 14 which position the shoulders 21 b and 22b in the right-and-left direction of the contacts as shown in part (a) of Fig. 2 and forward/backward positioning walls 15 which position the shoulders 21 b and 22b in the forward-and-backward direction as shown in part (b) of Fig. 2. The press fitting head 10 comes down and the contacts 21 and 22 of the connector 20 enter the vertical grooves 12 of the press fitting head 10. Consequently, with the contacts 21 and 22 positioned by the right/left positioning walls 14 and forward/backward positioning walls 15, the abutment sections 13 of the press fitting head 10 come into abutment with the shoulders 21 b and 22b of the contacts 21 and 22 from above, press down the contacts 21 and 22, and thereby press-fit the press fit sections 21 a and 22a of the contacts 21 and 22 into press fit holes 31 in the substrate 30. As the contacts 21 and 22 are positioned with respect to the press fit holes 31 in the substrate 30 by the right/left positioning walls 14 and forward/backward positioning walls 15, the shoulders 21 b and 22b of the contacts 21 and 22 are prevented from running off the abutment sections 13 of the press fitting head 10, making it possible to press-fit the press fit sections 21 a and 22a of the contacts 21 and 22 reliably into the press fit holes 31 in the substrate 30.

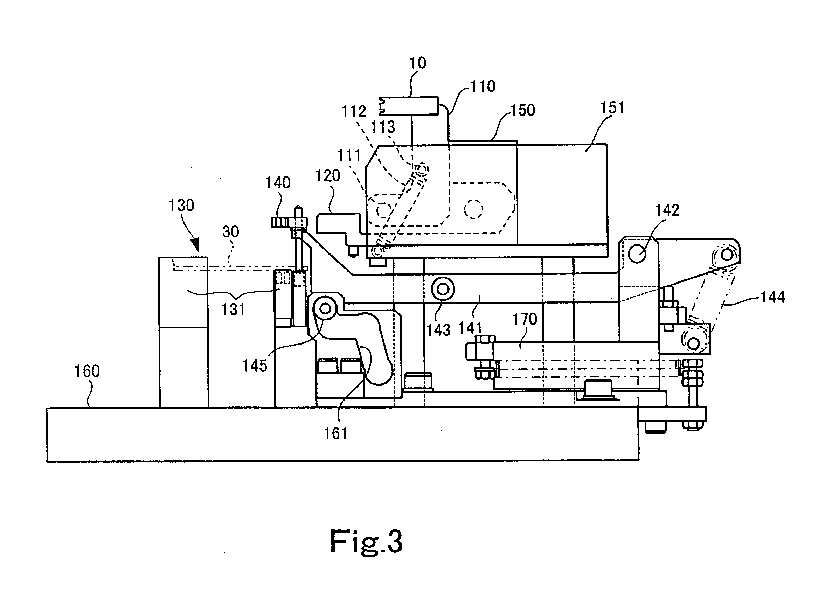

Figs. 3 to 8 are side views of a press fitting apparatus according to the embodiment of the present invention. The sequence of press fitting proceeds from Fig. 3 to Fig. 8.

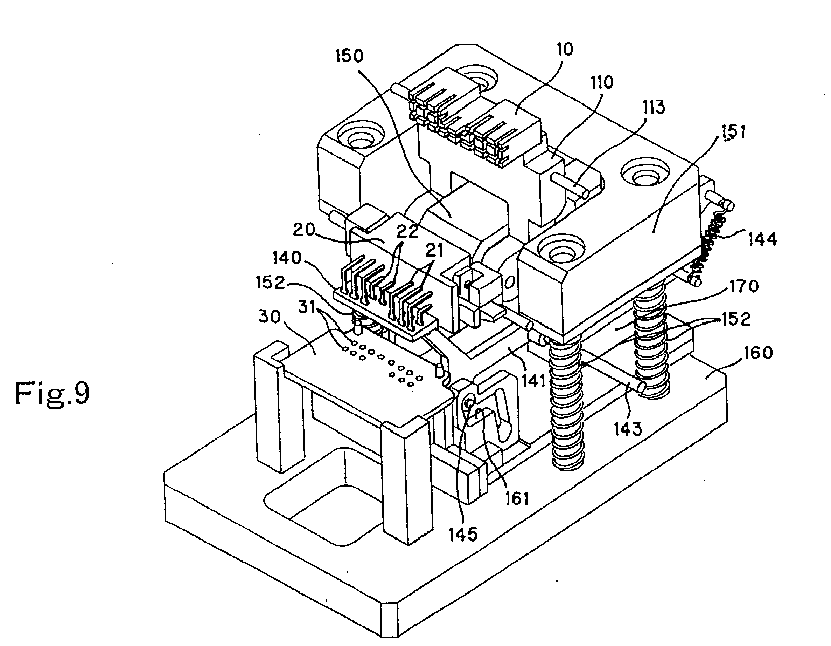

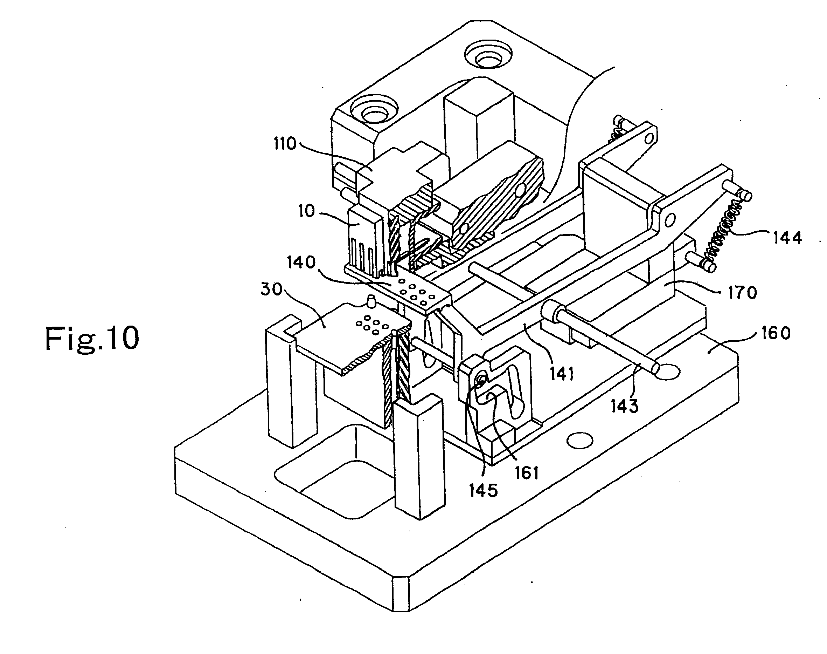

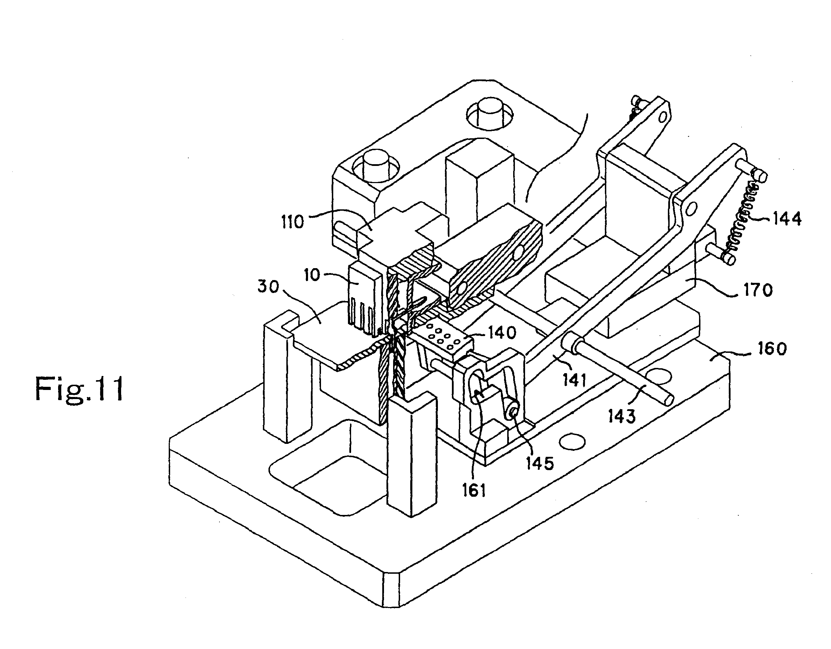

Fig. 9 is a perspective view of the press fitting apparatus whose side views are shown in Figs. 3 to 8. Figs. 10 and 11 are perspective views, partly in section, showing the press fitting apparatus before and after press fitting, respectively.

Fig. 3 shows a state in which a substrate 30 is mounted on a board support 131 of a substrate mounting section 130, but no connector is mounted on the connector mounting section 120. A locating plate 140 is placed near the connector mounting section 120. The placement location of the locating plate 140 shown in Fig. 3 is referred to herein as a positioning site.

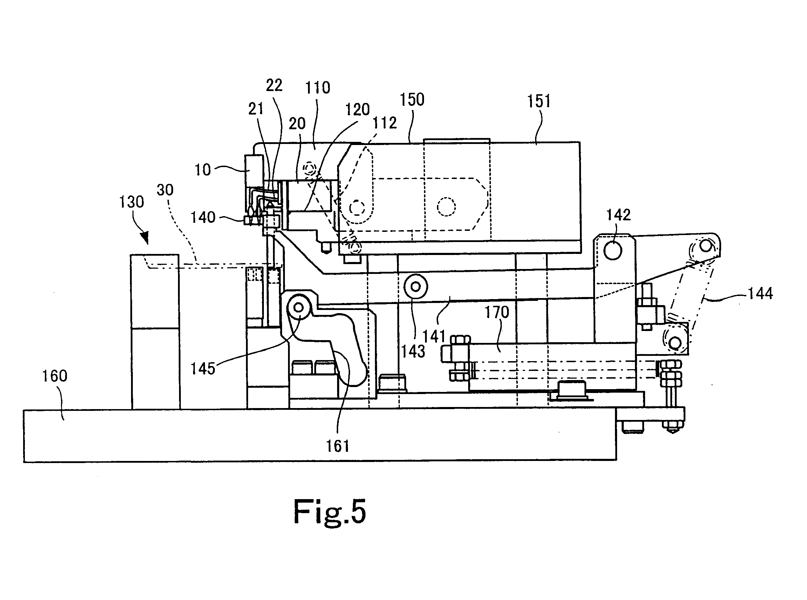

The press fitting head 10 is the same as the press fitting head shown in Figs. 1 to 4 and is secured to the support arm 110 as described above. The support arm 110 is rotatably supported around a rotating shaft 111 by a support arm holder 150. The support arm 110 rotates between a rest position where the press fitting head 10 is located above as shown in Fig. 3 and a press fitting position where the contacts 21 and 22 of the connector 20 enter the vertical grooves 12 (see part (a) of Fig. 2) of the press fitting head 10 as shown in Fig. 5. A coil spring 112 is used to stabilize the press fitting head 10 at both the rest position and press fitting position. According to this embodiment, the press fitting head 10 is rotated between the rest position in Fig. 3 and press fitting position in Fig. 5 by an operator with a control lever 113 attached to the support arm 110. Press fitting is done by a known press fit machine (not shown) which presses the top surface of the support arm 110 in Fig. 5. During the press fit operation, the support arm holder 150, the support arm 110, the press fitting head 10, and an upper base 151 move up and down as a unit.

Referring to Fig. 3, the support arm 110 and support arm holder 150 have their sides covered by the upper base 151 and are supported by the upper base 151. Incidentally, the coil spring 112 is not shown in Fig. 9 for simplicity of illustration.

The locating plate 140 is fastened to a tip of a link 141, which is rotatably supported by a rotating shaft 142 on a sliding board 170 which slides in the right-and-left direction in Fig. 3 with respect to a bed 160. The link 141 performs the operation described below, based on a cam mechanism consisting of a cam pin 145 installed in the link 141 and a cam groove 161 cut in a member fastened to the bed 160. The link 141 is also equipped with a control lever 143. Part of the following operation of the link 141 is performed by the operator with the control lever. Then, the link 141 returns to a state shown in Fig. 3 (state in which the locating plate 140 is placed at the positioning site in Fig. 3) by the action of a coil spring 144 and manual operation by the operator.

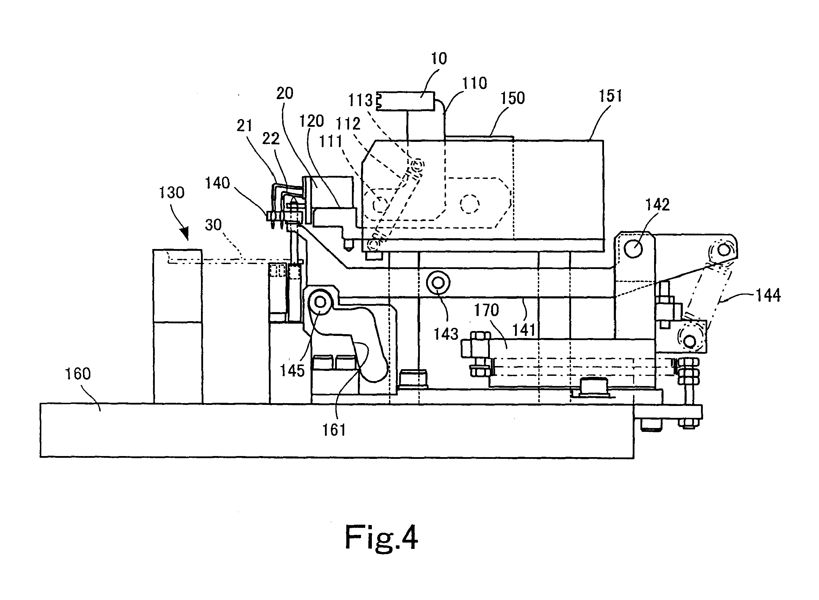

The configuration shown in Fig. 4 differs from the configuration shown in Fig. 3 in that the connector 20 is mounted on the connector mounting section 120. The connector 20 is the same as the one described with reference to Figs. 1 to 2. It has two rows-upper and lower rows- of roughly L-shaped contacts 21 and 22. Fig. 9 is a perspective view of the press fitting apparatus in the state shown in Fig. 4.

Figs. 4 and 9 show a state in which the connector 20 has been mounted on the connector mounting section 120 and its contacts 21 and 22 of the connector 20 have been positioned by the locating plate 140.

As shown in Fig. 9, at locations corresponding to the contacts 21 and 22 of the connector 20 positioned by the locating plate 140, the substrate 30 has the press fit holes 31 (see Fig. 2) into which the press fit sections 21 a and 22a (see part (b) of Fig. 2) of the contacts 21 and 22 are press-fitted.

Figs. 5 and 10 show a state after the press fitting head 10 is rotated to the press fitting position from the state shown in Fig. 4 (state in which the press fitting head 10 is at the rest position).

In the state shown in Figs. 5 and 10, the contacts 21 and 22 of the connector 20 are engaged with the vertical grooves 12 (see part (a) of Fig. 2) of the press fitting head 10. Internal structure of the vertical grooves 12 of the press fitting head 10 and relationship of the press fitting head 10 with the contacts 21 and 22 of the connector 20 have already been described with reference to Figs. 1 to 4, and thus description thereof will be omitted here.

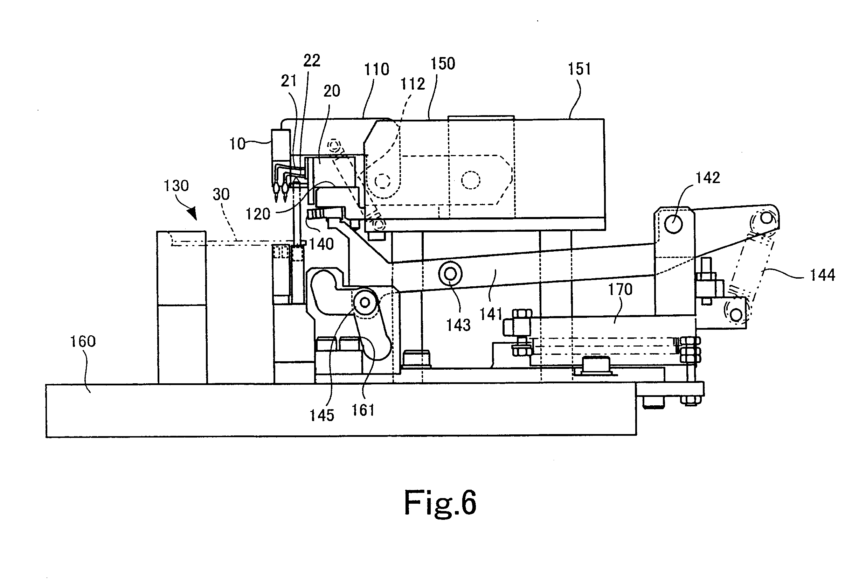

If the control lever 143 of the link 141 is operated when the press fitting head 10 is at the press fitting position as shown in Fig. 5, the cam pin 145 of the link 141 moves along the cam groove 161, causing the locating plate 140 to move away from the positioning site where it positions the contacts 21 and 22 of the connector 20 as shown in Fig. 6. However, the contacts 21 and 22 of the connector 20 have already been positioned in the vertical grooves 12 (see part (a) of Fig. 2) of the press fitting head 10 and even if the locating plate 140 moves away from the contacts 21 and 22, the contacts 21 and 22 remain positioned. During transition from the state shown in Fig. 5 to the state shown in Fig. 6, the sliding board 170 slides rightward in Fig. 6 with respect to the bed 160. The link 141 slides together with the sliding board 170, moving the cam pin 145 from the position shown in Fig. 5 to the position shown in Fig. 6.

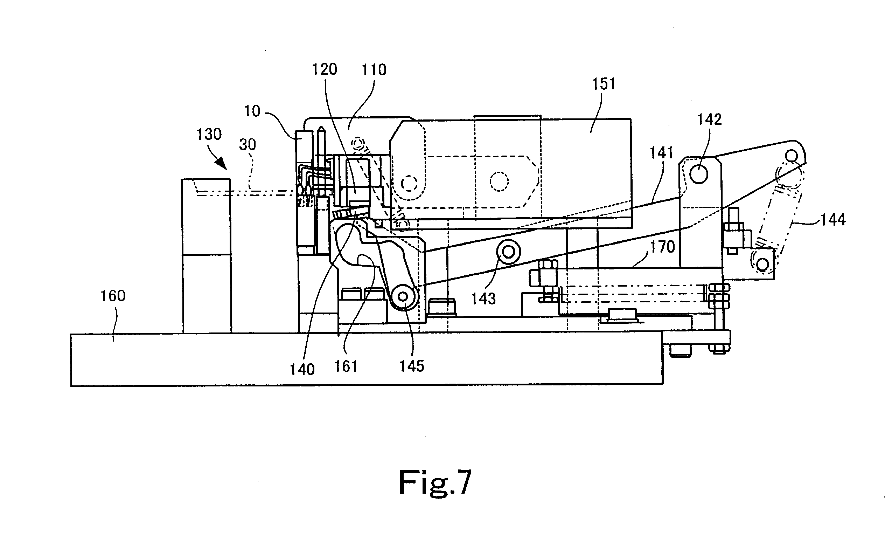

In the state shown in Fig. 6, when the top surface of the support arm 110 is pressed by the press fit machine (not shown) as shown in Figs. 7 and 11, the locating plate 140 moves downward in abutment with the bottom surface of the connector mounting section 120.

Figs. 7 and 11 show a state in which the support arm 110 has been pressed down by the press fit machine (not shown). When the control lever 113 is pressed down, the support arm 110, support arm holder 150 which holds the support arm 110, press fitting head 10 secured to the support arm 110, and the upper base 151 which supports them are pressed down as shown in Figs. 7 and 11. Consequently, the press fit sections 21 a and 22a (see part (b) of Fig. 2) of the contacts 21 and 22 of the connector 20 are press-fitted by the press fitting head 10 into the press fit holes 31 in the substrate 30. At this point, the upper base 151 is locked at the position shown in the figure.

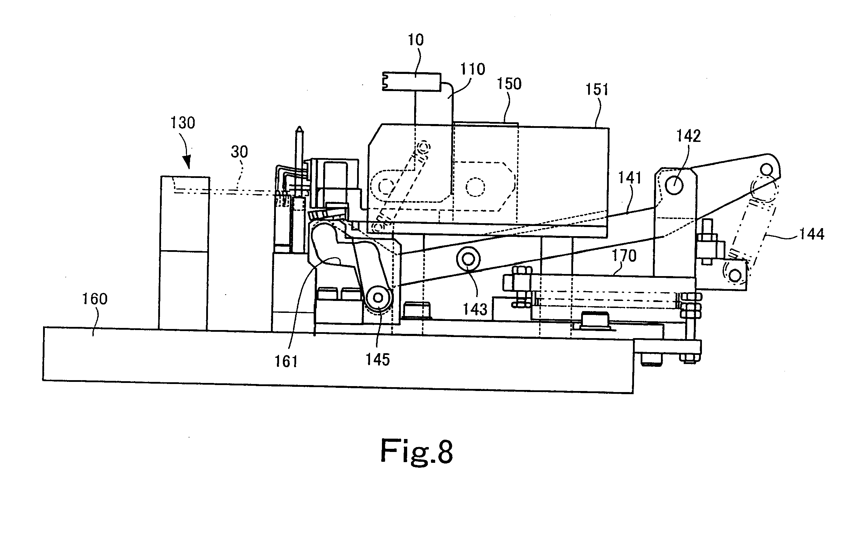

After the press fit machine rises, the press fitting head 10 returns to the rest position, located above, by the rotation of the support arm 110 as shown in Fig. 8. Then, the upper base 151 is unlocked and by the action of coil springs 152 shown in Fig. 9, the support arm holder 150, the support arm 110 held by the support arm holder 150, the press fitting head 10 secured to the support arm 110, and an upper base 151 move up as a unit to the position shown in Fig. 3. Then, by the action of the coil spring 144 and operation of the control lever 143 of the link 141 by the operator, the link 141 returns to the original position shown in Fig. 3. Consequently, the locating plate 140 fastened to the tip of the link returns to the positioning site.

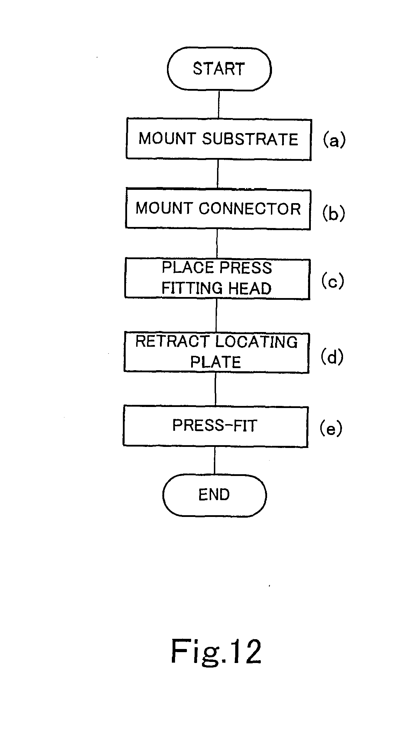

The press fitting apparatus and the operation thereof according to one embodiment of the present invention has been described so far. Now, a press fitting method on the press fitting apparatus will be summarized with reference to a flowchart shown in Fig. 12.

Fig. 12 is a flowchart of the press fitting method according to one embodiment of the present invention, where the method is performed on the press fitting apparatus shown in Figs. 3 to 11.

First, a substrate 30 is mounted on the substrate mounting section 130 (step (a)). In Fig. 3, the substrate 30 has already been mounted on the substrate mounting section 130.

Next, the connector 20 is mounted on the connector mounting section 120 (step (b)).

Here, the connector 20 is mounted on the connector mounting section 120 after the L-shaped legs of the contacts 21 and 22 of the connector are aligned by being inserted into holes in the locating plate 140.

Then, as shown in Fig. 5, the press fitting head 10 is placed above the L-shaped legs of the contacts 21 and 22 of the connector 20 (step (c)). Then, as shown in Figs. 6 and 7, the locating plate 140 retracts from the positioning site (step (d)), the press fitting head 10 is pressed down, and thereby the contacts 21 and 22 of the connector 20 are press-fitted into the press fit holes 31 in the substrate 30 (step (e)). Then, the substrate 30 and connector 20 which have gone through press fitting are removed, the initial state shown in Fig. 3 is restored as described above, and a new substrate is mounted. Through repetition of this cycle, substrates with a connector press-fitted are completed one by one. Incidentally, motor power or the like may be used instead of manual power to rotate the support arm 110 and move the link 141.

## Claims

1. Press fitting apparatus equipped with a substrate mounting section (130), a connector mounting section (120), and a press fitting head (10) which positions and press-fits roughly L-shaped legs of a connector (20) into a substrate (30), wherein the connector (20) has multiple rows of contacts (21,22) equipped with the legs and press fit sections (21 a,22a) provided near the lower ends of the legs, the press fitting apparatus further comprising:
a locating plate (140) which positions the lower ends of the legs,
wherein the locating plate (140) is retractable downwardly from a positioning site where the lower ends of the legs are positioned.

2. The apparatus according to claim 1, wherein the press fitting head (10) comprises:
abutment sections (13) which abut shoulders (21 b,22b) installed on top of the press fit sections (21 a,22a) of the connector;
first positioning walls (14) which position the shoulders (21 b,22b) in a first right-and-left direction; and
second positioning walls (15) which position the shoulders (21 b,22b) in a second forward-and-backward direction.

3. A method for press fitting, comprising the steps of:
mounting a substrate (30) on a substrate mounting section (130);
inserting roughly L-shaped legs of a connector (20) into holes in a locating plate placed at a predetermined positioning site to align the legs and mounting the connector(20) on a connector mounting section (120), wherein the connector (20) has multiple rows of contacts (21,22) equipped with the legs and press fit sections (21 a,22a) provided near the lower ends of the legs;
placing a press fitting head (10) on the legs;
retracting the locating plate (140) from the positioning site; and
lowering the press fitting head (10) and press-fitting the legs into press fit holes (31) in the substrate (30).
